# EUROPEAN PATENT APPLICATION

(11) **EP 2 693 498 A2**
(43) Date of publication of application: **05.02.2014**
(21) Application number: 13176603.2
(22) Date of filing: 16.07.2013
(51) Int. Cl.: H01L 33/00, H01L 33/20

(54) **Light emitting diode with undercut and manufacturing method thereof**

(30) Priority: 30.07.2012 TW 101127480
(71) Applicant: Lextar Electronics Corp., 30075 Hsinchu (TW)
(72) Inventor: Yu, Chang-Chin, 302 Hsinchu County (TW); Tang, Hsiu-Mu, 300 Hsinchu City (TW); Lin, Mong-Ea, 106 Taipei City (TW)
(74) Representative: Winter, Brandl, Fürniss, Hübner, Röss, Kaiser, Polte - Partnerschaft

(57) **Abstract**

An LED with undercut includes a first semiconductor layer, an illumination layer, a second semiconductor layer, a first electrode and a second electrode. The first semiconductor layer includes a first area and a second area. A first acute angle is included between a first slanted wall and a first top surface of the first area. The illuminating layer is formed on the second area. The second semiconductor is formed on the illuminating layer. The first and second electrodes are respectively formed on the first top surface and the second semiconductor layer. The first semiconductor layer on the second area, the illuminating layer and the second semiconductor layer on the first semiconductor layer form a MESA structure. The MESA structure includes a second slanted wall adjacent to the first area. A second acute angle is included between the second slanted wall and the first top surface.

## Description

### BACKGROUND

### Technical Field

Embodiments of the present invention relate to a light emitting diode. More particularly, embodiments of the present invention relate to the light emitting diode with undercut.

### Description of Related Art

Because of having advantages such as long service lifetime, compact size and low power consumption, a light emitting diode (LED) is widely used in various applications of light sources.

A common LED includes an epitaxial stack structure disposed on a substrate. The expitaxial stack structure includes an N-type semiconductor layer, a Multiple Quantum Wells (MQW) and a P-type semiconductor layer stacked sequentially. When the N-type semiconductor layer and the P-type semiconductor layer are applied with a voltage, electrons and electronic holes are driven to be combined in the MQW to emit light. A P-type electrode is disposed on the P-type semiconductor layer. Part of the p-type semiconductor layer and part of the MQW are etched to expose part of the N-type semiconductor layer, so as to dispose an N-type electrode.

The MQW and the P-type semiconductor layer positioned higher than the exposed N-type semiconductor layer are generally called a MESA structure. The lateral wall of the MESA structure vertically stands on the top surface of the N-type semiconductor layer, which may confine lights in the MQW and reduce the illumination efficiency.

In order to improve the illumination efficiency, some manufacturers proposed optical microstructures on the top surface of the MESA structure; nevertheless, these optical microstructures deteriorate the flatness of the P-type semiconductor layer.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

A light emitting diode (LED) with undercut is provided, and it can achieve high illumination efficiency without reducing the flatness of the surface of the semiconductor layer. In accordance with one embodiment of the present invention, a LED with undercut includes a first semiconductor layer, an illumination layer, a second semiconductor layer, a first electrode and a second electrode. The first semiconductor layer includes a first area and a second area. A side of the first area includes a first slanted wall, and the first area includes a first top surface. A first acute angle is included between the first slanted wall and the first top surface. The illuminating layer is formed on the second area of the first semiconductor layer. The second semiconductor layer is formed on the illuminating layer. The first electrode and the second electrode are respectively formed on the first top surface and the second semiconductor layer. Part of the first semiconductor layer on the second area, the illuminating layer and the second semiconductor layer on the part of the first semiconductor layer form a MESA structure. The MESA structure includes a second slanted wall adjacent to the first area. A second acute angle is included between the second slanted wall and the top surface of the first area.

In accordance with another embodiment of the present invention, a method for manufacturing a light emitting diode with undercut includes steps of: providing a substrate; forming a semiconductor epitaxial structure, wherein the semiconductor epitaxial structure including a buffer layer, a first semiconductor layer stacked on the buffer layer, an illumination layer stacked on the first semiconductor layer and a second semiconductor layer stacked on the illumination layer; forming a first hard mask on a portion of the semiconductor epitaxial structure; applying a first etching step to etch another portion of the semiconductor epitaxial structure not covered by the first hard mask to the first semiconductor layer, so that a part of the first semiconductor layer is exposed as a first area and the unexposed part of the first semiconductor layer is a second area; wherein the illumination layer, the second semiconductor layer and partial of the first semiconductor layer positioned on the second area form a MESA structure on the second area, wherein the MESA structure includes a second slanted wall, and a second acute angle is included between a first top surface of the first area and the second slanted wall; forming a second hard mask covering the MESA structure and partial of the first area; employing a second etching step to etch an area not covered by the second hard mask and forming a first slanted wall, a third slanted wall and a fourth slanted wall respectively on the sides of the first semiconductor layer, the buffer layer and the substrate, wherein a first acute angle is included between the first slanted wall and the first top surface, and the first slanted wall, the third slanted wall and the fourth slanted wall are coplanar.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:
Fig. 1 is a cross-sectional view of the LED with undercut in accordance with one embodiment of the present invention;
Fig. 2 is a cross-sectional view of the LED with undercut in accordance with another embodiment of the present invention;
Fig. 3 is a cross-sectional view of the LED with undercut in accordance with still another embodiment of the present invention;
Fig. 4 is a cross-sectional view of the LED with undercut in accordance with still another embodiment of the present invention; and
Figs. 5A to 5F are cross-sectional views of the LED with undercut during the manufacturing process in accordance with one embodiment of the present invention.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

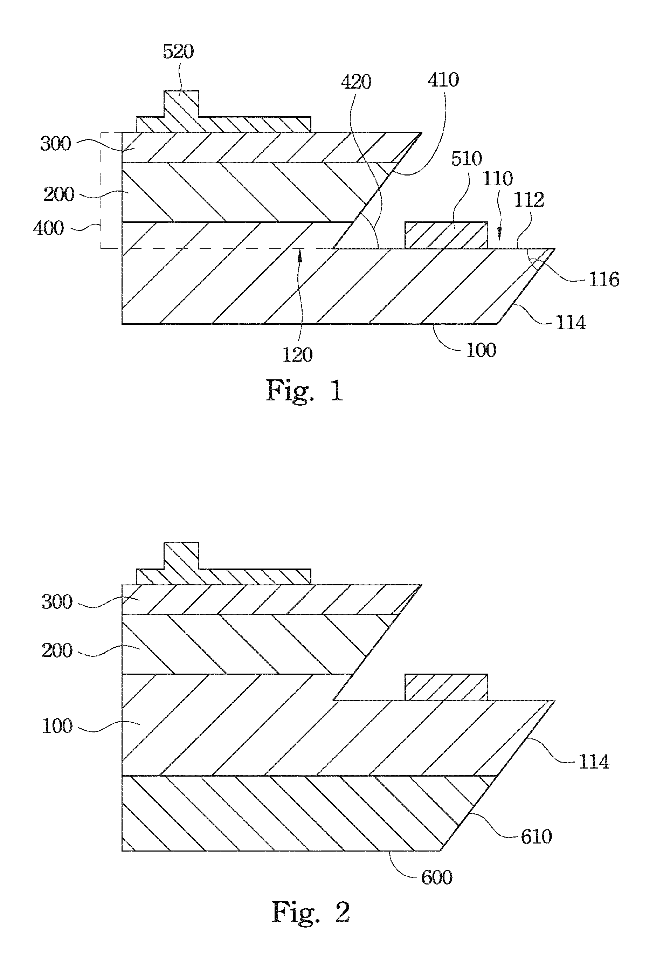

Fig. 1 is a cross-sectional view of the LED with undercut in accordance with one embodiment of the present invention. As shown in this figure, the LED with undercut includes a first semiconductor layer 100, an illumination layer 200, a second semiconductor layer 300, a first electrode 510 and a second electrode 520. The first semiconductor layer 100 includes a first area 110 and a second area 120. The side of the first area 110 includes a first slanted wall 114, and the surface of the first area 110 includes a first top surface 112. A first acute angle 115 is included between the first slanted wall 114 and the first top surface 112. The illuminating layer 200 is formed on the second area 120 of the first semiconductor layer 100. The second semiconductor layer 300 is formed on the illuminating layer 200. The first electrode 510 and the second electrode 520 are respectively formed on the first top surface 112 and the second semiconductor layer 300. Part of the first semiconductor layer 100 on the second area 120, the illuminating layer 200 and the second semiconductor layer 300 on this part of the first semiconductor layer 100 cooperate to form a MESA structure 400. The MESA structure 400 includes a second slanted wall 410 adjacent to the first area 110. A second acute angle 420 is included between the second slanted wall 410 and the top surface 112 of the first area 110.

Because the second slanted wall 410 obliquely stands on the first semiconductor layer 100, when the light generated from the illumination layer 200 propagates to the second slanted wall 410, it is more likely to be reflected toward the second semiconductor layer 300 by the second slanted wall 410, thereby improving the illumination efficiency. Further, the first slanted wall 114 can also assist to reflect the light upwards when the light propagates to the first slanted wall 114, thereby improving the illumination efficiency.

Fig. 2 is a cross-sectional view of the LED with undercut in accordance with another embodiment of the present invention. This embodiment is similar to which of Fig. 1, and the main difference is that the LED in this embodiment further includes a buffer layer 600. The buffer layer 600 is positioned under the first semiconductor layer 100, and the side of the buffer layer 600 adjacent to the first slanted wall 114 includes a third slanted wall 610. The first slanted wall 114and the third slanted wall 610 are coplanar.

Specifically, the third slanted wall 610 of the buffer layer 600 is adjacent to the first slanted wall 114, and the third slanted wall 610 and the first slanted wall 114 are on the same plane. In other words, the angle between the third slanted wall 610 and the first slanted wall 114 is about 180 degrees. Still in other words, the slanted angle of the third slanted wall 610 is equal to the slanted angle of the first slanted wall 114. Therefore, the third slanted wall 610 can assist to reflect the light when the light propagates to the third slanted wall 610, thereby improving the illumination efficiency.

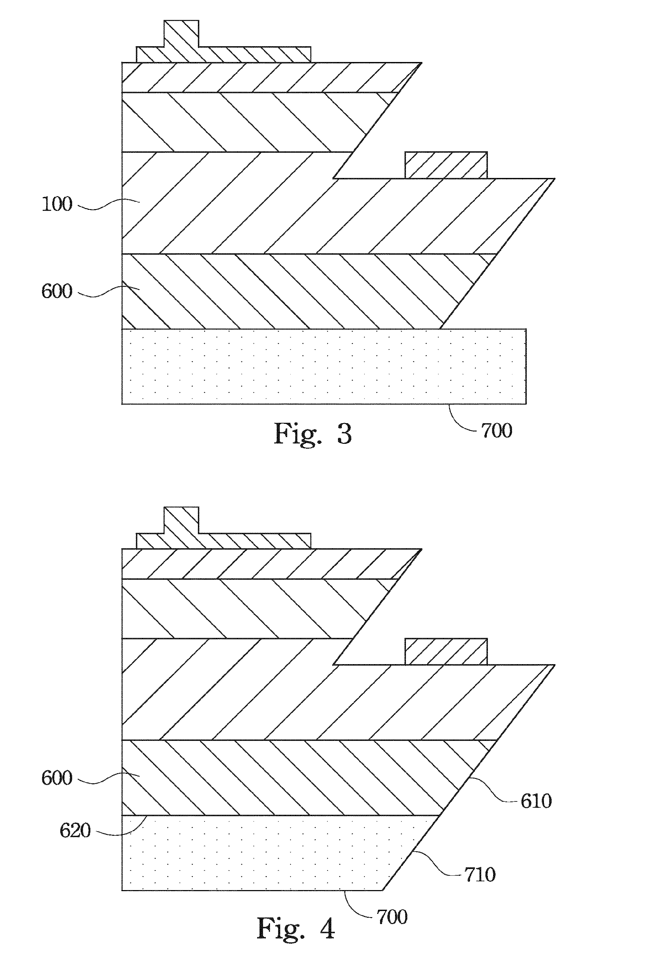

Fig. 3 is a cross-sectional view of the LED with undercut in accordance with still another embodiment of the present invention. This embodiment is similar to which of Fig. 2, and the main difference is that the LED in this embodiment further includes a substrate 700. The substrate 700 is positioned under the buffer layer 600. In other words, the buffer layer 600 is positioned between the first semiconductor layer 100 and the substrate 700.

Fig. 4 is a cross-sectional view of the LED with undercut in accordance with still another embodiment of the present invention. This embodiment is similar to which of Fig. 3, and the main difference is that the side of the substrate 700 adjacent to the third slanted wall 610 includes a fourth slanted wall 710. The third slanted wall 610 and the fourth slanted wall 710 are coplanar.

Specifically, the substrate 700 is positioned beneath the bottom surface 620 of the buffer layer 600, and the fourth slanted wall 710 is adjacent to the third slanted wall 610 of the buffer layer 600. The fourth slanted wall 710 and the third slanted wall 610 are on the same plane, namely, the slanted angle of the fourth slanted wall 710 is equal to the slanted angle of the third slanted wall 610. Therefore, the fourth slanted wall 710 can assist to reflect the light when the light propagates to the fourth slanted wall 710, thereby improving the illumination efficiency.

Referring back to Fig. 1, in some embodiments, the first slanted wall 114 and the second slanted wall 410 are respectively positioned on the opposite sides of the first top surface 112 of the first area 110. Specifically, the first slanted wall 114 is adjacent to the side of the first top surface 112 far away from the second area 120, and the second slanted wall 410 is adjacent to the boundary between the first area 110 and the second area 120.

In some embodiments, by the slope shape of the second slanted wall 410, the cross-sectional area of the MESA structure 400 gradually increases along the direction from the first semiconductor layer 100 to the second semiconductor layer 300. In other words, the projections of the illumination layer 200 and the second semiconductor layer 300 that are projected to the first semiconductor layer 100 cover part of the first area 110.

In some embodiments, by the slope shape of the first slanted wall 114, the cross-sectional area of the first semiconductor layer 100 gradually increases along the direction from the first semiconductor layer 100 to the second semiconductor layer 300.

In some embodiments, the first acute angle 116 ranges from about 30 degrees to about 89 degrees. In some embodiments, the second acute angle 420 ranges from about 30 degrees to about 89 degrees.

In some embodiments, the first semiconductor layer 100 is a N-type semiconductor layer, and the first electrode 510 is an N electrode. The second semiconductor layer 300 is a P-type semiconductor layer, and the second electrode 520 is a P electrode. For example, the first semiconductor layer 100 is formed by a nitride semiconductor doped with N-type impurity, such as n-GaN, which is formed by doping the group 4A elements, such as Silicon, in the pure GaN. The second semiconductor layer 300 is a nitride semiconductor doped with P-type impurity, which is formed by doping the group 2A elements, such as Magnesium, in the pure GaN.

In some embodiments, the first semiconductor layer 100 is a P-type semiconductor layer, and the first electrode 510 is a P electrode. The second semiconductor layer 300 is an N-type semiconductor layer, and the second electrode 520 is an N electrode. For example, the first semiconductor layer 100 is a nitride semiconductor doped with P-type impurity, which is formed by doping the group 2A elements, such as Magnesium, in the pure GaN. The second semiconductor layer 300 is formed by a nitride semiconductor doped with N-type impurity, such as n-GaN, which is formed by doping the group 4A elements, such as Silicon, in the pure GaN.

In some embodiments, the illumination layer 200 includes a plurality of quantum wells to assist the electrons and the electronic holes provided by the first semiconductor layer 100 and the second semiconductor layer 300 to combine therein.

In some embodiments, the buffer layer 600 may include, but is not limited to include, a nitride semiconductor without doping impurity, such as U-GaN.

In some embodiments, the substrate 700 may be, but is not limited to be, a sapphire substrate.

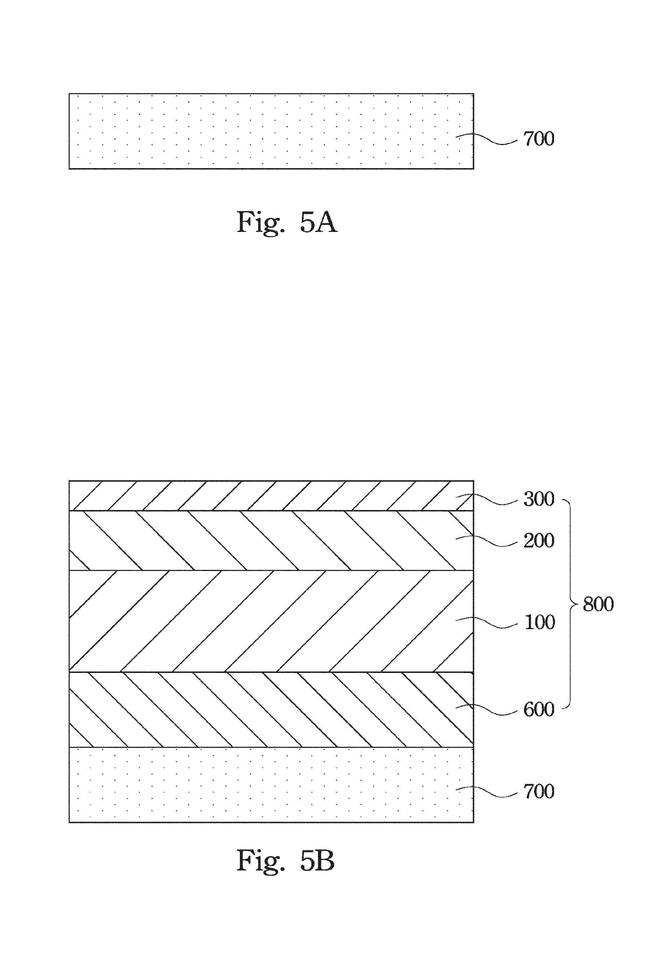

Figs. 5A to 5F are cross-sectional views of the LED with undercut during the manufacturing process in accordance with one embodiment of the present invention.

In Fig. 5A, a substrate 700 is provided, and the substrate 700 may be, but is not limited to be, a sapphire substrate.

In Fig. 5B, a semiconductor epitaxial structure 800 is formed on the substrate 700. The semiconductor epitaxial structure 800 includes a buffer layer 600, a first semiconductor layer 100 stacked on the buffer layer 600, an illumination layer 200 stacked on the first semiconductor layer 100, and a second semiconductor layer 300 stacked on the illumination layer 200. For example, at first, the buffer layer 600 is grown on the substrate 700. Then, the first semiconductor layer 100 is grown on the buffer layer 600, and then, illumination layer 200 is grown on the first semiconductor layer 100. The second semiconductor layer 300 can be lastly grown on the illumination layer 200, so that the semiconductor epitaxial structure 800 can be formed.

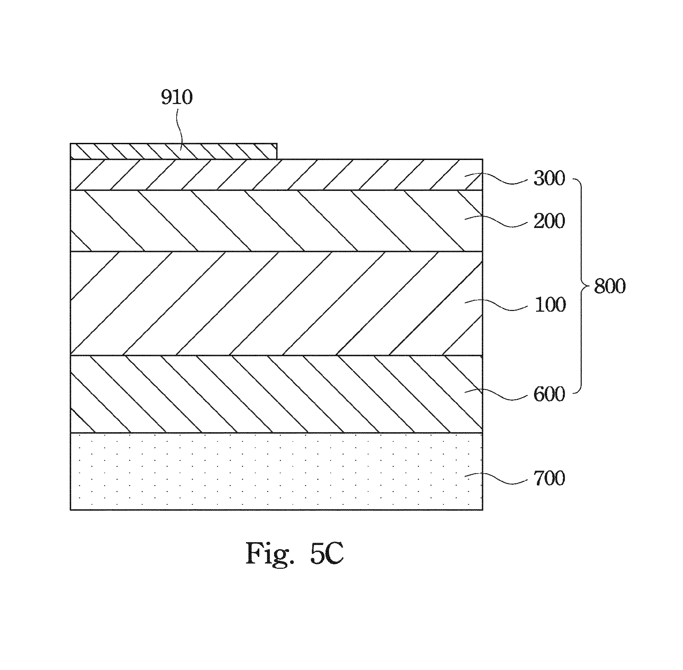

In Fig. 5C, a first hard mask 910 can be formed on part of the semiconductor epitaxial structure 800. For example, the first hard mask 910 can cover the area predetermined to form the MESA structure (See FIG. 1). The material of the first hard mask 910 include, but is not limited to include, SiO₂ so that the lateral wall of the first hard mask 910 can vertically stand on the semiconductor epitaxial structure 800, thereby facilitating to form the slope shape of the second slated wall 410 (See Fig. 1). It is noted that, if the PR (photo resist) were used as the first hard mask 910, it would be difficult to form the second slanted wall 410 because the cross-sectional area would increase from upside to downside. Therefore, SiO₂ is employed as the material of the first hard mask 910 in this embodiment.

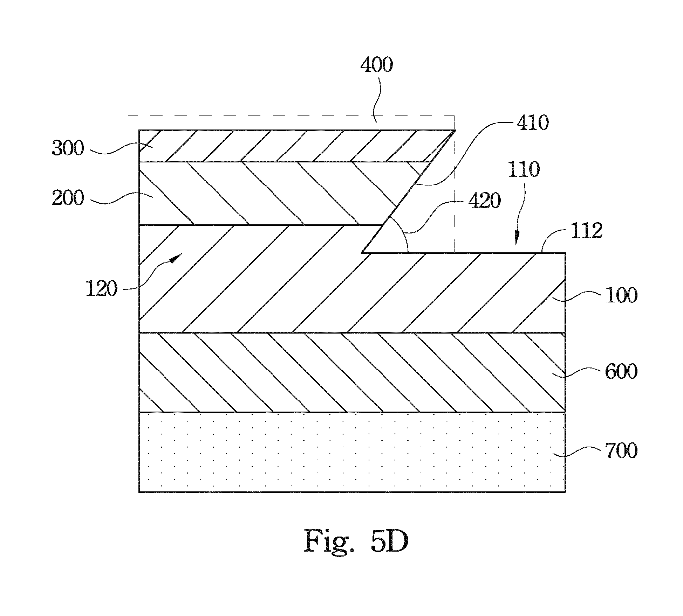

In Fig. 5D, a first etching step is applied for etching another part of the semiconductor epitaxial structure 800 not covered by the first hard mask 910 to the first semiconductor layer 100, so that part of the first semiconductor layer 100 is exposed as a first area 110 and the unexposed part of the first semiconductor layer 100 is a second area 120. The illumination layer 200, the second semiconductor layer 300 and part of the first semiconductor layer 100 positioned on the second area 120 form a MESA structure 400. The MESA structure 400 includes a second slanted wall 410. A second acute angle 420 is included between a first top surface 112 of the first area 110 and the second slanted wall 410.

Specifically, the first etching step in Fig. 5D can be a process of dry etching. The dry etching can be performed by, for example, ICP (Inductively Coupled Plasma) or RIE (Reactive Ion Etching). In some embodiments, the pressure performing ICP is higher than 3 Pa, so as to use strong isotropic etching and chemical etching to form the second slanted wall 410.

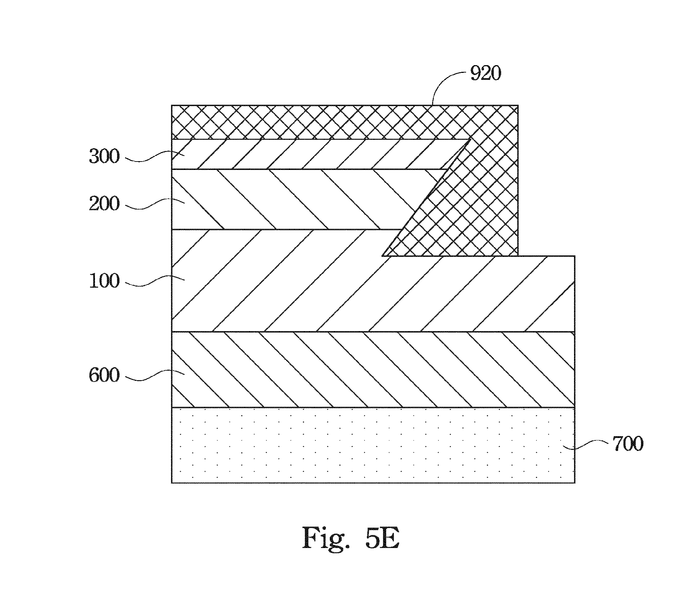

In Fig. 5E, a second hard mask 920 can be formed to cover the MESA structure 400 and part of the first area 110. The material of the second hard mask 920 can be, but is not limited to be, SiO₂ so that the lateral wall of the second hard mask 920 can vertically stand on the first semiconductor layer 100, thereby facilitating to form the slope shape of the first slanted wall 114 (See Fig. 1). It is noted that, if the PR (photo resist) were used as the second hard mask 920, it would be difficult to form the first slanted wall 114 because the cross-sectional area would increase from upside to downside. Therefore, SiO₂ is employed as the material of the first hard mask 920 in this embodiment.

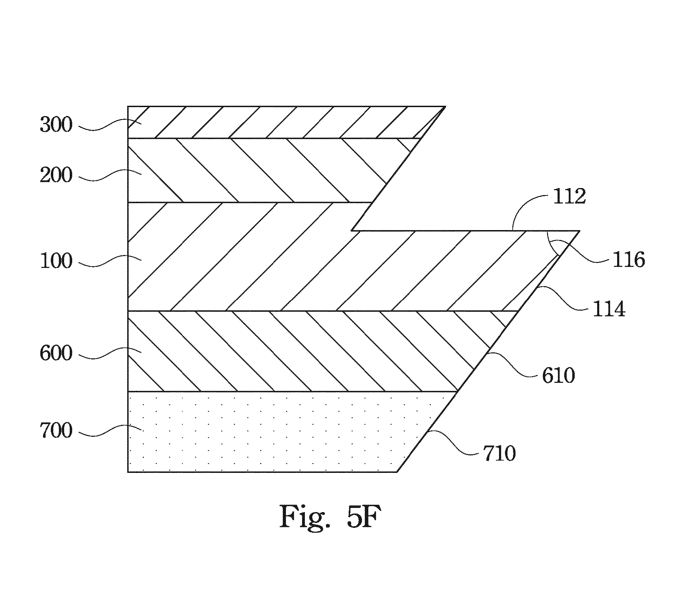

In Fig. 5F, a second etching step is applied for etching the area not covered by the second hard mask 920 and forming a first slanted wall 114, a third slanted wall 610 and a fourth slanted wall 710 respectively on the sides of the first semiconductor layer 100, the buffer layer 600 and the substrate 700. A first acute angle 116 is included between the first slanted wall 114 and the first top surface 112. The first slanted wall 114, the third slanted wall 610 and the fourth slanted wall 710 are coplanar. The second etching step in FIG. 5F can be performed by wet etching.

In some embodiments, another step can be further included, and in this step, the first electrode 510 and the second electrode 520 (See Fig. 1) can be respectively formed on the first semiconductor layer 100 and the second semiconductor layer 300.

In some embodiments, another step can be further included, and in this step, the substrate 700 can be removed, so as to form the structure similar to which is shown in Fig. 2.

In some embodiments, another step can be further included, and in this step, the buffer layer 600 and the substrate 700 can be removed, so as to form the structure similar to which is shown in Fig. 1.

## Claims

1. A light emitting diode with undercut, **characterized by** comprising:
a first semiconductor layer comprising a first area and a second area, wherein a side of the first area comprises a first slanted wall, and the first area comprises a first top surface, and a first acute angle is included between the first slanted wall and the first top surface;
an illuminating layer formed on the second area of the first semiconductor layer;
a second semiconductor layer formed on the illuminating layer; and
a first electrode and a second electrode respectively formed on the first top surface and the second semiconductor layer,
wherein a part of the first semiconductor layer on the second area, the illuminating layer and the second semiconductor layer on the part of the first semiconductor layer form a MESA structure, wherein the MESA structure comprises a second slanted wall adjacent to the first area, and a second acute angle is included between the second slanted wall and the top surface of the first area.

2. The light emitting diode with undercut of claim 1, **characterized by** further comprising a buffer layer positioned under the first semiconductor layer, wherein a side of the buffer layer adjacent to the first slanted wall comprises a third slanted wall being coplanar with the first slanted wall.

3. The light emitting diode with undercut of claim 2, **characterized by** further comprising a substrate positioned under the buffer layer, and a side of the substrate adjacent to the third slanted wall comprises a fourth slanted wall being coplanar with the third slanted wall.

4. The light emitting diode with undercut from the each one of claims 1 to 3, **characterized in that** the first acute angle ranges from about 30 degrees to about 89 degrees.

5. The light emitting diode with undercut from the each one of claims 1 to 3, **characterized in that** the second acute angle ranges from about 30 degrees to about 89 degrees.

6. A method for manufacturing a light emitting diode with undercut, **characterized by** comprising the steps of:
providing a substrate;
forming a semiconductor epitaxial structure, wherein the semiconductor epitaxial structure comprising a buffer layer, a first semiconductor layer stacked on the buffer layer, an illumination layer stacked on the first semiconductor layer, and a second semiconductor layer stacked on the illumination layer;
forming a first hard mask on a portion of the semiconductor epitaxial structure;
employing a first etching step to etch another portion of the semiconductor epitaxial structure not covered by the first hard mask to the first semiconductor layer, so that a part of the first semiconductor layer is exposed as a first area and the unexposed part of the first semiconductor layer is as a second area, wherein the illumination layer, the second semiconductor layer and partial of the first semiconductor layer positioned on the second area form a MESA structure on the second area, wherein the MESA structure comprises a second slanted wall, and a second acute angle is included between a first top surface of the first area and the second slanted wall;
forming a second hard mask covering the MESA structure and partial of the first area;
employing a second etching step to etch an area not covered by the second hard mask and forming a first slanted wall, a third slanted wall and a fourth slanted wall respectively on the sides of the first semiconductor layer, the buffer layer and the substrate, wherein a first acute angle is included between the first slanted wall and the first top surface, and the first slanted wall, the third slanted wall and the fourth slanted wall are coplanar.

7. The method for manufacturing the light emitting diode with undercut of claim 6, **characterized in that** the first etching step is by dry etching.

8. The method for manufacturing the light emitting diode with undercut of claim 7, **characterized in that** the dry etching is performed by ICP (Inductively Coupled Plasma) or RIE (Reactive Ion Etching).

9. The method for manufacturing the light emitting diode with undercut of claim 6, **characterized in that** the second etching step is performed by wet etching.

10. The method for manufacturing the light emitting diode with undercut of claim 6, **characterized by** further comprising a step of forming a first electrode and a second electrode on the first semiconductor layer and the second semiconductor layer respectively.

11. The method for manufacturing the light emitting diode with undercut of claim 6, **characterized by** further comprising a step of removing the substrate.

12. The method for manufacturing the light emitting diode with undercut of claim 6, **characterized by** further comprising a step of removing the substrate and the buffer layer.

13. The method for manufacturing the light emitting diode with undercut from the each one of claims 6 to 12, **characterized in that** the first acute angle ranges from about 30 degrees to about 89 degrees.

14. The method for manufacturing the light emitting diode with undercut from the each one of claims 6 to 12, **characterized in that** the second acute angle ranges from about 30 degrees to about 89 degrees.
